# EUROPEAN PATENT APPLICATION

(11) **EP 4 835 434 A1**
(43) Date of publication of application: **04.11.2026**
(21) Application number: 25173955.3
(22) Date of filing: 02.05.2025
(51) Int. Cl.: G01N 1/28, G01N 1/32

(54) **CONTROL SYSTEM, METHOD AND COMPUTER PROGRAM FOR A SAMPLE PREPARATION DEVICE, SAMPLE PREPARATION DEVICE**

(71) Applicant: Leica Mikrosysteme GmbH, 1170 Wien (AT)
(72) Inventor: WURZINGER, Paul, 1170 Wien (AT); KATZENGRUBER, Matthias, 1170 Wien (AT); AOUDJIT, Slimane, 1170 Wien (AT); EDTHOFER, Florian, 1170 Wien (AT)
(74) Representative: 2SPL Patentanwälte PartG mbB

(57) **Abstract**

Examples relate to a control system, a method, and a computer program for a sample preparation device, and to a sample preparation device comprising such a control system. A control system (110) for a sample preparation device (100) is configured to obtain a plurality of sensor data sets of a positioning sensor (120) of the sample preparation device, with each sensor data set being indicative of a position of at least one reference point on a sample (10) within the sample preparation device, control, between obtaining successive sensor data sets of the plurality of sensor data sets, a positioning mechanism (130) of the sample preparation device to change at least one of a position or orientation of the sample relative to the positioning sensor by a defined distance and/or defined angle, and determine at least one of the position or orientation of the sample within the sample preparation device based on the positions of the at least one reference point in the plurality of sensor data sets.

## Description

### Technical field

Examples relate to a control system, a method, and a computer program for a sample preparation device, and to a sample preparation device comprising such a control system.

### Background

The analysis of faulty components, such as integrated circuits, is performed to improve the design and/or manufacturing of the component. In many cases, a researcher or engineer is aware of where a fault may have occurred, which allows the researcher or engineer to target a specific portion of a sample of the component. To allow the researcher or engineer to analyze this specific portion, e.g., using an electron microscope, this portion may need to be uncovered. To define a target for a sample preparation machine in order to uncover the portion of interest, high-resolution 2D or 3D data recorded on the specimen itself (e.g., µCT (micro computed tomography) scans, X-ray images, high-resolution light microscopy, electron microscopy of the surface, etc.) or known from the production process (e.g., layout of lithography masks, design data, measurement protocols, etc.) may be used. In order to carry out mechanical processing based on this data, which exposes the target with the desired precision, the sample is first aligned with respect to the processing planes.

Alignment is performed by probing accessible reference points using one or more measuring systems that are aligned with respect to the machining device. These measuring systems are subject to restrictions with regard to reaching preparation points, measuring direction and measuring resolution.

There may be a desire to provide an improved concept for aligning a sample in a sample preparation device.

### Summary

This desire is addressed by the subject matter of the independent claims.

Various examples of the present disclosure are based on the finding that the highly precise positioning mechanisms of a sample preparation device, which are usually used to precisely position the sample relative to the sample preparation tool (i.e., for alignment), can also be used to improve the precision of the determination of the sample's position within a sample chamber. In particular, measuring points (i.e., reference points) and known geometric features (e.g., straight lines) can be probed several times. Defined movements (e.g., pivoting around an axis, displacement) can be carried out by a positioning mechanism of the processing device between the probing operations. The sensor data obtained can then be matched with the initial data using an optimization procedure (e.g., least square fit) in order to achieve improved accuracy. The proposed concept can be used to combine precise positioning options of a control system with probing methods in order to determine the most accurate, preferably 3D positioning of the sample in the sample preparation device. On this basis, a (3D) determination of a hidden target area is also possible, and the target area can thus be prepared. The proposed concept thus provides a concept for targeting based on data on sample.

Some aspects of the present disclosure relate to a control system for a sample preparation device. The control system comprises one or more processors and one or more storage devices. The control system is configured to obtain a plurality of sensor data sets of a positioning sensor of the sample preparation device. Each sensor data set is indicative of a position of at least one reference point on a sample within the sample preparation device. The control system is configured to control, between obtaining successive sensor data sets of the plurality of sensor data sets, a positioning mechanism of the sample preparation device to change at least one of a position or orientation of the sample relative to the positioning sensor by at least one of a defined distance or defined angle. The control system is configured to determine at least one of the position or orientation of the sample within the sample preparation device based on the positions of the at least one reference point in the plurality of sensor data sets. This way, even when only one reference point is accessible during a given measurement, an improved precision can be achieved, by using the known displacement of the sample and the multiple measurements to determine the alignment.

In general, it may be desirable to determine the position and orientation of the sample in three dimensions. While a (telecentric) microscope can be used as a tool for measuring positions and distances in two dimensions, it may be unsuitable for determining positions along the depth axis, at least without further techniques, such as structured lighting. Another such technique is based on changing the distance between the positioning sensor (e.g., the microscope) and the sample. When the distance between the positioning sensor and the sample is changed, unless the reference point of the sample is and remains centered below the positioning sensor, the position of the reference point in the sensor data also changes, which can be used to determine the reference point's position in three dimensions. Thus, the control system may be configured to control the positioning mechanism to change the position of at least one reference point along a depth axis defined by the positioning sensor, resulting in a change in distance between the positioning sensor and the at least one reference point. The control system may be configured to determine the position and/or orientation of the sample with respect to a three-dimensional coordinate system.

In many cases, sample preparation devices are capable of rotating the sample. For example, the control system may be configured to control the positioning mechanism to rotate a sample stage hosting the sample around an axis. By rotating the sample, the position of the reference point(s) is changed in two dimensions (including distance), which is beneficial for the proposed technique. Thus, rotating the sample may allow determining a three-dimensional position and/or orientation of the sample. Moreover, a rotation of the sample allows fitting the positions against a circle that is based on the (known) axis of rotation of the sample stage.

In many cases, as outlined above, to obtain the sensor data sets based on different relative positions and/or orientations between the positioning sensor and the sample, the sample may be moved using the positioning mechanism. Accordingly, the control system may be configured to control the positioning mechanism to laterally and/or vertically move a sample stage hosting the sample relative to the positioning sensor, thereby causing a change in the angle of view of the positioning sensor on the sample.

As an alternative, or in addition to the movement of the sample, the positioning sensor may also be moved. This may be beneficial in scenarios in which the position and/or orientation of the positioning sensor can be changed more freely or more precisely than the position or orientation of the sample. In other words, the control system may be configured to control the positioning mechanism to at least one of laterally move, vertically move, or rotate the positioning sensor.

To obtain a more precise position and/or orientation of the sample, known geometric properties of the sample and/or of the movement may be used to determine the position and/or orientation of the sample. For example, the control system may be configured to use a fitting algorithm to determine the position and/or orientation of the sample based on the positions of the at least one reference point indicated by at least two sensor data sets, by fitting the positions to a geometric shape of the sample and/or a geometric shape based on the changed relative position or orientation. In the former case, if the shape of the sample is known or follows common rules (e.g., includes straight lines), knowledge of the shape of the sample may be used to more precisely determine the position of the reference point(s), and thus the position and/or orientation of the sample. Also, the positions of the reference point(s) in the sensor data sets follow the relative movement between the sample and the positioning system, providing another known geometric relationship that can be used to improve the precision of the positioning.

One such known geometric relationship is given if the relative change in position or orientation includes a rotation (of the sample or positioning sensor). Such a rotation leads to the positions of the reference point(s) changing according to a circle around the axis of rotation. Accordingly, the control system may be configured to, if the change in position or orientation is based on a rotation around an axis, fit the positions of the at least one reference point against at least one circle being based on the rotation.

Another known or assumed geometric relationship is the use of straight lines in the design of the sample. For example, the control system may be configured to, if the sensor data indicates the position of two or more reference points located at the same edge of the sample, use the fitting algorithm to determine a straight line representing the edge of the sample. The control system may be configured to determine the position and/or orientation of the sample based on the straight line representing the edge of the sample. Straight lines are very common in samples, such as semiconductor chips, and are therefore highly valuable in precisely determining the position and orientation of various edges of the sample.

A special case is present if two straight edges meet at a corner. Corners are often useful for determining the position and/or orientation of a sample, as they can be easily localized in the sets of sensor data as well as models of the sample. For example, the control system may be configured to, if the sensor data indicates the position of two sets of two or more reference points being located at two edges of the sample, with the two edges meeting at a corner of the sample, use the fitting algorithm to determine straight lines representing the edges of the sample, with the straight lines intersecting at the corner of the sample. The control system may be configured to determine the position of the corner of the sample based on the position and orientation of the straight lines. The control system may then use the position of the corner of the sample to determine the position and/or orientation of the sample.

One highly precise reference for fitting the measured reference points is a model of the sample. For example, the control system may be configured to use the fitting algorithm to fit the positions to a two-dimensional model (e.g., a two-dimensional Computer Aided Design, CAD, drawing) or three-dimensional model (e.g., a three-dimensional CAD or Computer Aided Manufacturing, CAM, model) of the sample.

The preparation of samples is a highly complex task, performed by a highly skilled operator, who can achieve the best results by continuously monitoring the preparation of the sample using a microscope. In the proposed concept, this microscope, which may be a telecentric microscope suitable for determining the position of reference points at a given focal plane, may also be used to generate the sensor data that are used to determine the positions of the reference point(s). In other words, the control system may be configured to obtain the sensor data sets of a microscope.

There are other types of positioning sensors that can be used. For example, the sensor data sets may comprise at least one of distance information or coordinate information. The control system may be configured to obtain the sensor data sets of one of a mechanical probing device, an electrical probing device, or a distance- or coordinate-coded sensor configured to provide distance-dependent sensor data. Thus, the positions of the reference points can be determined without requiring a (calibrated) microscope.

In general, suitable reference points may be those at an edge or corner of the sample. Accordingly, the control system may be configured to determine the position of the at least one reference point at an edge or corner of the sample. Reference points at edges or corners facilitate the process, as they can be identified more easily in the sets of sensor data.

In some examples, human input may be used to identify the reference points in the sensor data. For example, the control system may be configured to provide a user interface for a user of the sample preparation device. The user interface may comprise an input modality for selecting the position of the at least one reference point in the sensor data sets. The control system may be configured to determine the position and/or orientation of the sample within the sample preparation device based on the position of the at least one reference point selected by the user. This way, the user, who often has precise knowledge about the geometric shape of the sample, can select reference points that are suitable for determining the position or orientation of the sample with few measurements.

Alternatively, or additionally, the control system may be configured to automatically detect the position of the at least one reference point in the sensor data sets. This may reduce the human effort required for determining the position or orientation while increasing the implementation complexity of the control system.

As outlined above, in many cases, a highly precise model of the sample may be used during sample preparation, for example, so that the target portion of the sample can be precisely uncovered. This model can also be used to automatically select suitable reference point(s) in the sensor data sets. For example, the control system may be configured to automatically detect the position of the at least one reference point based on a two- or three-dimensional model of the sample. For example, the control system may use straight edges or corners to select suitable reference points. In some examples, the model may comprise information on one or more possible reference points. This may guide the control system and may lead to fewer measurements being required to precisely determine the position or orientation of the sample.

In some examples, the control system is further configured to control the positioning mechanism to change the position and/or orientation of the sample to a target position and/or orientation based on the determined position and/or orientation of the sample.

An aspect of the present disclosure relates to a sample preparation device comprising the control system, a chamber for holding the sample, a sample preparation mechanism, the positioning sensor, and the positioning mechanism. For example, the sample preparation device may use the control system to precisely determine the position and/or orientation of the sample, and/or to change the position and/or orientation of the sample to a target position and/or orientation.

There are various techniques that can be used for sample preparation. The proposed technique is primarily used for sample preparation devices that allow precise movement of the sample relative to a sample preparation tool. In particular, the sample preparation device may be a device for mechanically milling, polishing, and/or cutting the sample.

Some aspects of the present disclosure relate to a method for a sample preparation device. The method comprises obtaining a plurality of sensor data sets of a positioning sensor of the sample preparation device. Each sensor data set is indicative of a position of at least one reference point on a sample within the sample preparation device. The method comprises controlling, between obtaining successive sensor data sets of the plurality of sensor data sets, a positioning mechanism of the sample preparation device to change at least one of a position or orientation of the sample relative to the positioning sensor by a defined distance and/or defined angle. The method comprises determining at least one of the position or orientation of the sample within the sample preparation device based on the plurality of sensor data sets.

Another aspect of the present disclosure relates to a computer program having a program code for performing the above method when the program is executed on a processor.

### Short description of the Figures

Some examples of apparatuses and/or methods will be described in the following by way of example only, and with reference to the accompanying figures, in which:
- Fig. 1: shows a schematic diagram of an example sample preparation device and control system;
- Figs. 2a to 2c: show schematic drawings of a technique for determining a three-dimensional position and orientation of a sample based on a rotation of a sample;
- Fig. 3: shows a schematic drawing of a relationship between positions of a reference point when a sample comprising the reference point is rotated around an axis of rotation;
- Fig. 4: shows a schematic drawing of a technique for determining the position of a corner of a sample based on the positions of reference points located at edges of the sample;
- Fig. 5: shows a flow chart of an example of a method for a sample preparation device; and
- Fig. 6: shows a schematic diagram of a system comprising a microscope and a computer system.

### Detailed Description

Various examples will now be described more fully with reference to the accompanying drawings in which some examples are illustrated. In the figures, the thicknesses of lines, layers and/or regions may be exaggerated for clarity.

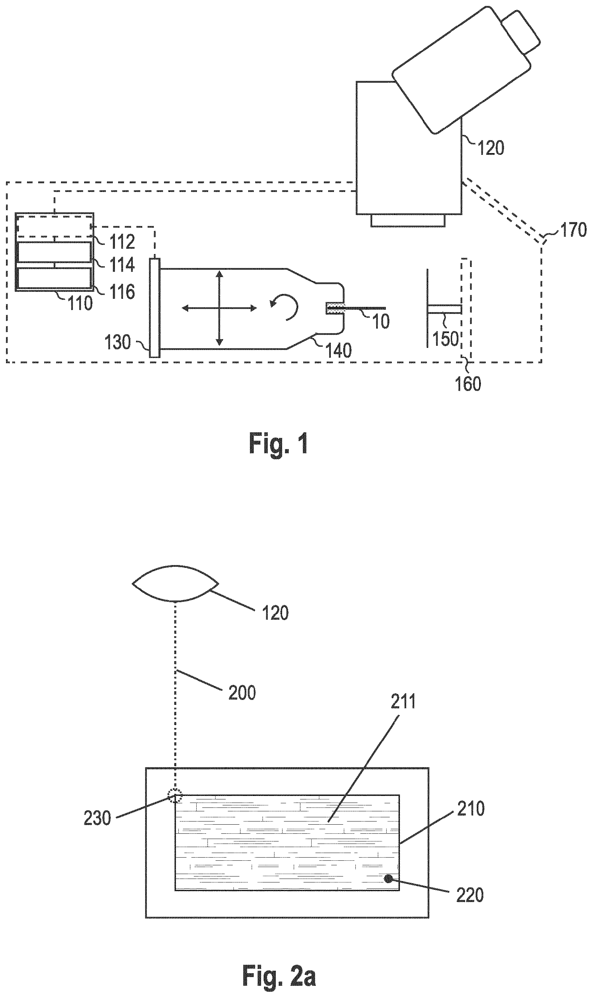

Fig. 1 shows a schematic diagram of an example sample preparation device 100. In general, a sample preparation device, such as the sample preparation device 100, is a device used to prepare material specimens, such as integrated circuits, for detailed microscopic analysis, such as scanning electron microscopy or incident light microscopy. These devices may utilize a variety of machining technologies, such as sawing, milling, grinding, and polishing, to create cross-sections and smooth surfaces of materials for examination. Accordingly, the sample preparation device 100 may be a device for mechanically milling, polishing, and/or cutting a sample. For example, the sample preparation device 100 comprises at least one sample preparation mechanism 150, such as a sawing disc, grinding disc, or polishing disc, for preparing the sample. A sample preparation device may consolidate multiple preparation operations into a single instrument, reducing preparation time and the risk of damaging the specimen, and often includes features like automation, integrated microscopy for observation during processing, and precision feed mechanisms for working with diverse materials.

When preparing a sample using the sample preparation device, highly precise alignment between the sample preparation mechanism and the sample is of utmost importance to prevent loss of specimen detail and to attain the best surface quality required for techniques such as scanning electron microscopy (SEM), incident light microscopy, and transmission electron microscopy (TEM). This precise alignment, combined with instrument stability, ensures smooth surfaces and accurate machining of the specimen throughout multiple processes, thereby eliminating the need for re-localization and examination with separate instruments.

In the sample preparation device, inside a chamber, a sample 10 is held by a sample holder and hosted by a sample stage 140. For example, the sample stage may be moved by a positioning mechanism 130. For example, as indicated in Fig. 1, the positioning mechanism may be configured to move the sample stage 140 with the sample 10 in at least one of up to three dimensions, e.g., up and down, left and right, and/or towards the sample preparation mechanism 150 and away from the sample preparation mechanism 150. Moreover, the positioning mechanism 130 may be configured to rotate the sample stage 140 around an axis. For example, the positioning mechanism 130 may be implemented using a combination of stepper motors and linear rails. For example, the stepper motors may control movement in the up/down, left/right, and towards/away from the sample preparation mechanism directions by driving the sample stage 140 along corresponding linear rails. An additional rotary motor, also connected to the sample stage 140, may be configured to rotate the sample stage 140 around an axis.

Similar to the positioning mechanism 130 of the sample stage 140, the sample preparation device 100 may comprise a positioning mechanism 160 for the sample preparation mechanism 150. For example, the sample preparation mechanism 150 may be moved by a second positioning mechanism 160. For example, the second positioning mechanism 160 may be configured to move the sample preparation mechanism 150 in at least one of up to three dimensions, e.g., up and down, left and right, and/or towards the sample stage 140 and away from the sample stage 140. For example, the second positioning mechanism 160 may be implemented using a combination of stepper motors and linear rails. For example, the stepper motors may control movement in the up/down, left/right, and towards/away from the sample stage 140 directions by driving the sample preparation mechanism 150 along corresponding linear rails.

The sample stage 140 further comprises a positioning sensor for determining the position of at least one reference point on the sample 10. In general, various types of positioning sensors may be used for this purpose.

For example, the positioning sensor may comprise a mechanical or electrical probing device, such as a mechanical probing system with length or coordinate measurement or an electrical touch probe with length or coordinate measurement. A mechanical probing device may be configured to determine the position of a sample, and specifically a reference point on the sample, within a sample chamber by physically contacting the sample and measuring the resulting displacement of the probe or a time at which an electrical contact is established. The former is typically achieved using encoders or other position sensors integrated into the probing mechanism to translate the physical contact into quantifiable positional data. The latter is typically achieved using a current or voltage sensor configured to measure a current or voltage caused by the contact. The probing device moves until the probe contacts the sample, and the sensors then report the coordinates of that location within the chamber's coordinate system.

Additionally, or alternatively, the positioning sensor may comprise a distance- or coordinate-coded sensor, e.g., a capacitive or inductive sensor, configured to provide distance-dependent sensor data. Distance- or coordinate-coded sensors are non-contact measurement systems that detect linear positions or spatial coordinates by continuously generating a signal that correlates directly with the distance to an object, such as the sample. These signals can be analog or digitally encoded, and their output varies based on the physical proximity of a target object or reference point. For example, if the distance- or coordinate-coded sensor is a capacitive sensor, it may provide sensor data representing a capacitance measured by the capacitive sensor. When the edge or feature of the sample comes into range, the sensor detects a change in capacitance, which is represented in the sensor data. By correlating the measurement with the position of the positioning sensor or sample stage, the position of the sample or of a reference point thereof can be determined.

In the example shown in Fig. 1, a microscope 120 is used as the positioning sensor. For example, an optical microscope with a known position of the optical axis and/or with the focal point or position coded by a measuring system (e.g. stereo or camera microscope with fixed and measured focal axis) may be used. A microscope, and specifically a calibrated telecentric microscope, can be used to determine a sample's position, and a reference point on that sample, within a sample preparation device's chamber by precisely measuring the two-dimensional coordinates of the reference point in the microscope's image plane. Because the microscope is calibrated, these image coordinates can be directly correlated to real-world coordinates within the sample chamber. A telecentric microscope minimizes perspective distortion, ensuring that the measured position is accurate regardless of slight changes in the sample's distance from the objective lens. This allows for accurate positioning and mapping of the sample within the device. The following explanation assumes that light microscope sensor data sets are used as sensor data sets.

The components of the sample preparation device 110 are tied together and controlled by a control system 110 that is part of the sample preparation device 100. For example, the control system 110 may be a computer system that controls the sample preparation device 110. The control system 110 comprises one or more processors 114 and one or more storage devices 116. Optionally, the control system 110 further comprises one or more interfaces 112. The one or more processors 114 are coupled to the one or more storage devices 116 and to the one or more interfaces 112. In general, the functionality of the control system 110 may be provided by the one or more processors 114, in conjunction with the one or more interfaces 112 (for exchanging data/information with one or more other entities, such as the positioning sensor 120, the positioning device 130, the sample preparation mechanism 150, the second positioning mechanism 160, a touchscreen user interface 170, and/or a positioning mechanism for changing the position of the positioning sensor 120), and with the one or more storage devices 116 (for storing information, such as machine-readable instructions of a computer program being executed by the one or more processors 114). In general, the functionality of the one or more processors 114 may be implemented by one or more processors 114 executing machine-readable instructions. Accordingly, any feature ascribed to the one or more processors 114 may be defined by one or more instructions of a plurality of machine-readable instructions. The control system 110 may comprise the machine-readable instructions, e.g., within the one or more storage devices 116.

In the proposed concept, the control system 110 is used to determine a position and/or orientation of the sample within the chamber. In this context, the position of the sample may be a single position that is defined for the sample. For example, a two-dimensional model or three-dimensional model of the sample may define an origin point, center point, etc. for the sample, which may be used to represent the position of the sample. Alternatively, the position of the sample may correspond to the positions of points (e.g., corners) defining a shape of the sample. For example, if the sample has a cuboid shape, the position of the sample may correspond to the positions of the eight corners of the cuboid shape. The orientation of the sample may refer to how the sample is rotated around its center point, defining its angular position in three-dimensional space, e.g., using angles like pitch, yaw, and roll.

To determine the sample's position and/or orientation, sensor data of the positioning sensor is used. The control system 110 is configured to obtain a plurality of sensor data sets of (e.g., from) the positioning sensor 120 (e.g., the microscope 120 or another type of positioning sensor) of the sample preparation device. Each sensor data set is indicative of a position of at least one reference point on the sample 10. In other words, the position of the sample (and in particular of the reference point(s)) may be measured, multiple times, by the positioning sensor, with the control system 110 processing the sensor data sets to interpret the sensor data and determine the reference point(s)' position in the sensor data.

Between the measurements, the relative position and/or orientation between the sample and the positioning sensor is changed. In particular, the control system 110 is configured to control, between obtaining successive sensor data sets of the plurality of sensor data sets, a positioning mechanism 130 of the sample preparation device to change at least one of a position or orientation of the sample relative to the positioning sensor by a defined distance and/or defined angle. This may be done by changing the position or orientation of the sample. For this purpose, the positioning mechanism 130 may, as shown in Fig. 1, change the position or orientation of the sample by moving and/or rotating the sample stage 140. For example, the control system 110 may be configured to control the positioning mechanism to laterally and/or vertically move a sample stage hosting the sample relative to the positioning sensor, thereby causing a change in the angle of view of the positioning sensor on the sample. Additionally, or alternatively, the control system 110 may be configured to control the positioning mechanism to rotate a sample stage hosting the sample around an axis 220. Alternatively, the relative position and/or orientation between the sample and the positioning sensor may be changed by moving or rotating the positioning sensor. In other words, the control system 110 may be configured to control the positioning mechanism to at least one of laterally move, vertically move, or rotate the positioning sensor.

To align the sample with the sample preparation mechanism 150, the position and orientation of the sample as well as the position of the sample preparation mechanism 150 are to be aligned in three dimensions. Some positioning sensors, such as the microscope 120, require additional effort to provide sensor data that is indicative of the three-dimensional positions of the reference points. To obtain suitable sensor data, the distance between the reference point(s) and the positioning sensors may be changed as part of the change in relative position/orientation. In other words, the control system 110 may be configured to control the positioning mechanism to change the (relative) position of at least one reference point along a depth axis defined by the positioning sensor 120, resulting in a change in distance between the positioning sensor and the at least one reference point. This can be done by rotating the sample, moving the sample along the up/down axis (in case the positioning device is mounted on top of the sample) or one of the other axes (in case the positioning device is mounted to the side of the sample), or by moving or rotating the positioning sensor.

The control system 110 is configured to determine at least one of the position or orientation of the sample within the sample preparation device based on the positions of the at least one reference point in the plurality of sensor data sets, e.g., with respect to a three-dimensional coordinate system. In the proposed concept, the use of multiple positions of the reference point(s) is used to improve the precision of the determined position/orientation, and, in some cases, to determine the position along the depth axis of the positioning sensor. To give a simple example: If a first sensor data set indicates that the position of the reference point is at (*x*₁, *y*₁, *z*₂), and the sample or the positioning sensor is moved by (0,0, *z*₃), the subsequently measured sensor data set should indicate that the reference point is at (*x*₁, *y*₁, *z*₂ + *z*₃). If the position indicated by the subsequent measurement is not exactly (*x*₁, *y*₁, *z*₂ + *z*₃), adjusted values for (*x, y, z*) may be calculated based on the difference between the positions indicated by the measurements.

This approach can be extended to cover not only vertical/lateral movements, but also rotations. For example, if the axis of rotation is known relative to the coordinate system in which the reference point(s)' positions are represented, it is possible to determine the position the reference point should have after rotating the sample stage (or the positioning sensor), e.g., using Rodrigues' rotation formula or using a rotation matrix. For example, using Rodrigues' rotation formula, if a first sensor data set indicates that the position of the reference point is at P = (*x*₁, *y*₁, *z*₂), the axis of rotation is defined by a unit vector k and the rotation angle *θ*, the new position *P*' after the rotation is given by: *P' = P cos*(*θ*) *+* (*k* × *P*)*sin*(*θ*) *+ k*(*k · P*)(1 *- cos*(*θ*)) where × represents cross product and · represents the dot product.

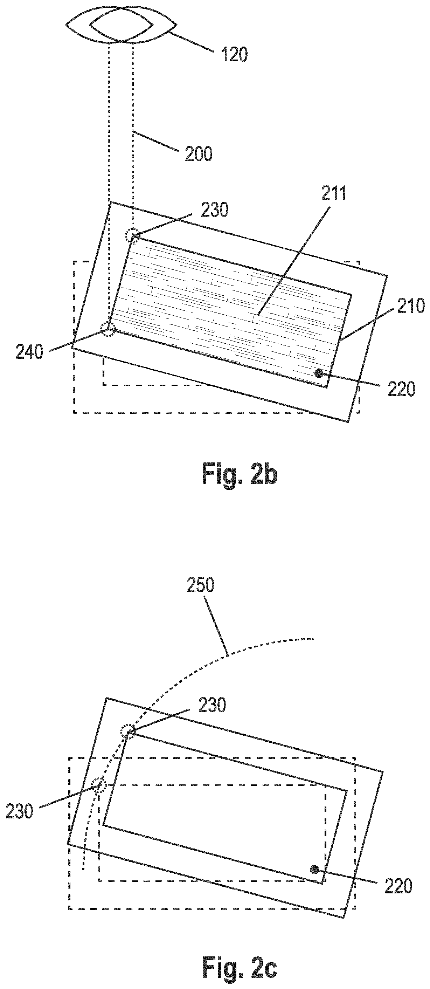

This approach is now discussed in more detail with reference to Figs. 2a to 3. Figs. 2a to 2c show schematic drawings of a technique for determining a three-dimensional position and orientation of a sample based on a rotation of a sample. Fig. 2a shows a sample 210 with an outer contour (represented by the corner point 230, which is used as the first reference point) and an inner structure 211, which is the object of the target preparation. The external structure can be probed with the light microscope 120, for example, by bringing the corner point 230 into the optical axis (e.g., marked in the image by a dashed line). As the viewing direction of the microscope is fixed, points that are covered by parts of the sample above them cannot be included in the measurement. For this reason, the sample is rotated around the axis 220 by a defined angle so that, for example, a further contour point 240 (a second reference point) becomes visible. The projected distance between the contour points can be measured either by a coded displacement of the sample or microscope or from one or more images (e.g., using telecentric imaging), with the focus being readjusted if needed.

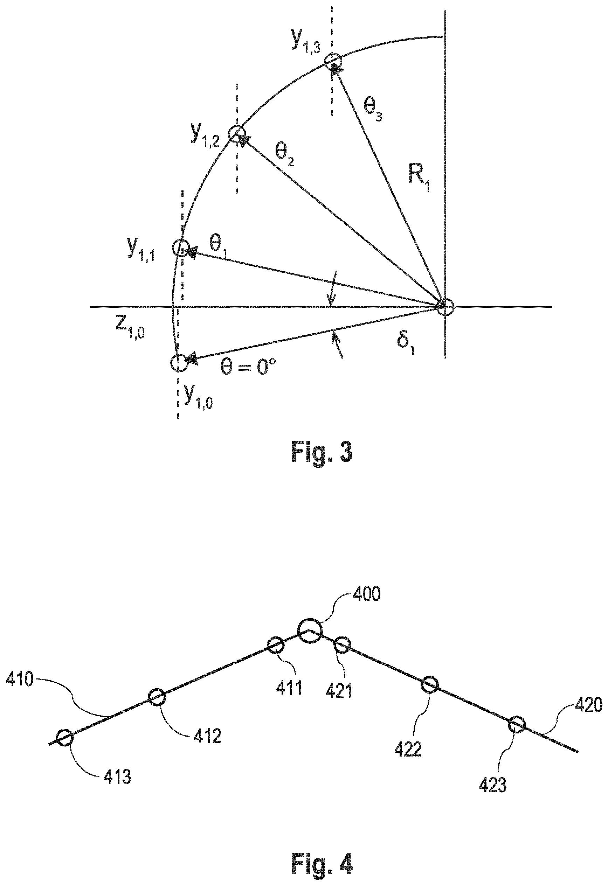

Fig. 3 shows a schematic drawing of a relationship between positions of a reference point when a sample comprising the reference point is rotated around an axis of rotation. Fig. 3 shows schematically how a three-dimensional measurement of the position of a measuring point can be carried out with a known axis of rotation, even with a fixed viewing direction (here: vertically downwards): The unknown variables for the non-tilted sample are the distance to the axis of rotation (R₁) and the vertical distance to the plane containing the axis of rotation (z_{1,0}, equivalent to the angle δ₁). To determine these two variables, the sample can now be tilted by defined angles (*θ*₁, *θ*₂, *θ*₃) and the projected distance to the axis of rotation can be measured for each of the angles. From this, the variables can be calculated for each pair of angles. For example, the following equations may be used: ${z}_{1 , 0} = {y}_{1 , 0} tan {δ}_{1} = {R}_{1} sin {δ}_{1}$ ${y}_{1 , 0} = {R}_{1} cos {δ}_{1}$ ${y}_{1 , 1} = {R}_{1} cos \left({θ}_{1}+{δ}_{1}\right)$ ${y}_{1 , 2} = {R}_{1} cos \left({θ}_{2}+{δ}_{1}\right)$ ${y}_{1 , 3} = {R}_{1} cos \left({θ}_{3}+{δ}_{1}\right)$

If tilting and measurement are automated, a relatively large number of measurement points can also be recorded.

In many cases, the geometry of the sample and/or the change in position may be used as another factor for improving the precision of the determined position and/or orientation. In other words, the control system 110 may be configured to use a fitting algorithm (such as least square fitting) to determine the position and/or orientation of the sample based on the positions of the at least one reference point indicated by at least two sensor data sets, by fitting the positions to a geometric shape of the sample and/or a geometric shape based on the changed relative position or orientation. For example, as shown in Figs. 2c and 3, in the case of a rotation, the movement of the reference point(s) is dictated by the axis of rotation, with the positions of the reference point forming a circle 250 around the axis of rotation 220. Thus, the control system 110 may be configured to, if the change in position or orientation is based on a rotation around an axis 220, fit the positions of the at least one reference point against at least one circle 250 based on the rotation. For example, the accuracy of the calculation of the position and/or orientation of the sample can be increased if it is taken into account that all rotated reference points lie on a circle 250 and a least square fit (or another optimization) to the circle may be used accordingly.

Similarly, if the sample has an edge, and multiple reference points are placed on the edge, the reference points may be fitted to a straight line representing the edge of the sample. This is illustrated in Fig. 4. Fig. 4 shows a schematic drawing of a technique for determining the position of a corner of a sample based on the positions of reference points located at edges of the sample. Fig. 4 shows schematically how known geometric features of the outer shape of the specimen can be used to carry out the most precise measurement possible: Several measurement points (e.g., reference points 411-413 and 421-423 respectively) are recorded along each of the two straight lines (410, 420). The property of the straightness of the geometric shape is used via a least square fit (or another optimization method) to precisely determine the positions/orientations of the straight lines from these measurement points. Thus, the control system 110 may be configured to, if the sensor data indicates the position of two or more reference points being located at the same edge of the sample (forming a straight line), use the fitting algorithm to determine a straight line representing the edge of the sample, and to determine the position/orientation of the sample based on the straight line representing the edge of the sample.

The corner point 400 then results as the intersection of the two straight lines. Accordingly, the control system 110 may be configured to, if the sensor data indicates the positions of two sets of two or more reference points located at two edges of the sample, with the two edges meeting at a corner of the sample, use the fitting algorithm to determine straight lines representing the edges of the sample, with the straight lines intersecting at the corner of the sample, and to determine the position of the corner of the sample based on the positions and orientations of the straight lines.

In some examples, the control system 110 may be configured to automatically adjust the straight lines to linear contours in the image, taking the image as a reference for the straight lines. In some examples, the control system 110 may be configured to derive the straight lines (and other geometric features) from a model or CAD drawing of the sample. In other words, the control system 110 may be configured to use the fitting algorithm to fit the positions to a two-dimensional or three-dimensional model of the sample.

In the previous examples, it was assumed that the reference point(s) is/are detected in the sensor data and that their positions are subsequently determined, without describing how this is done. In some examples, the selection/identification of reference point(s) in the sensor data may be a manual process. For example, the control system 110 may be configured to provide a user interface for a user of the sample preparation device, e.g., via the (touch) screen 170. This user interface may be used by the user to identify/select reference point(s) in the sensor data sets. For example, the user interface may comprise an input modality (e.g., a mouse/trackpad-based input modality, a touchscreen-based input modality, a trackball-based input modality, a button-based input modality, etc.) for selecting the position of the at least one reference point in the sensor data sets. The control system 110 may be configured to determine the position and/or orientation of the sample within the sample preparation device based on the position of the at least one reference point selected by the user.

As an alternative, the control system 110 may be configured to automatically detect the at least one reference point in the sensor data. In other words, the control system 110 may be configured to automatically detect the position of the at least one reference point in the sensor data sets. For example, the control system 110 may be configured to determine the position of the at least one reference point at an edge or corner of the sample. For example, the control system 110 may be configured to use an off-the-shelf image processing algorithm or machine learning model to detect the position and orientation of edges and/or the position of corners in the sensor data sets and to place the at least one reference point at an edge or corner of the sample, as represented by the respective sensor data set. For example, the control system 110 may be configured to, upon detection of an edge of the sample in a sensor data set, place at least two reference points at the edge of the sample and to determine the positions of the at least two reference points. Then, the control system 110 may place a straight line such that it aligns with the edge in the sensor data set, and the positions of the at least two reference points may be fitted to the straight line being aligned with the edge. The control system 110 may be configured to, upon detection of two edges that intersect, place at least two reference points at each of the edges of the sample and determine the positions of the at least two reference points per edge. Then, the control system 110 may place two straight lines such that they align with the respective edges in the sensor data set, and the positions of the at least two reference points per edge may be fitted to the respective straight line being aligned with the edge. In addition, the position of the corner, that is, the intersection between the two edges, may be determined based on the point at which the two straight lines intersect.

In many cases, the geometry of the sample is known to the user of the sample preparation device, for example, from a 3D scan, from a 2D model (e.g., CAD drawing) or 3D model (e.g., CAD/CAM model). This geometry may be used to help in placing the reference point(s). For example, the control system 110 may be configured to automatically detect the position of the at least one reference point based on a two- or three-dimensional model of the sample. For example, in the case of the sensor data sets comprising a microscope image, the control system 110 may be configured to identify at least one suitable reference point in the two- or three-dimensional model, for example, at an edge or corner of the model, or the model may contain information on one or more possible reference points. The control system 110 may be configured to use image projection to generate a plurality of 2D projections of the three-dimensional model of the sample (with the 2D projections comprising a marker at the position of the at least one reference point), and compare the plurality of 2D projections with the microscope image to determine a 2D projection that matches the viewing angle of the microscope 120. Then, the control system 110 may use image registration techniques, for example, based on landmarks visible in the 2D projection and the microscope image, to align the 2D projection with the microscope image. The control system 110 may transfer the marker(s) shown in the 2D projection to the corresponding microscope image to determine the at least one reference point in the microscope image. The control system 110 can then determine the position of the at least one reference point in the microscope image, for example, by using the calibration data for the microscope/microscope image.

In the proposed concept, in some examples, not only the position, but also the orientation of the sample is determined. This can be done using the position(s) of the reference points. For example, the control system 110 may be configured to determine at least one straight line representing at least one edge of the sample based on the positions of at least two reference points, and use the straight line to determine the orientation of the sample. For example, a reference orientation of the sample may be defined in a two- or three-dimensional model of the sample. The control system may be configured to match the at least one straight line to an edge of the sample in the two- or three-dimensional model of the sample, and determine an angular offset between the orientation of the at least one straight line and the orientation of the corresponding edge in the two- or three-dimensional model to determine the orientation of the sample.

Once the position and/or orientation of the sample is determined, the control system may be configured to change the position and/or orientation of the sample to a target position and/or orientation, for example, using the positioning device 130.

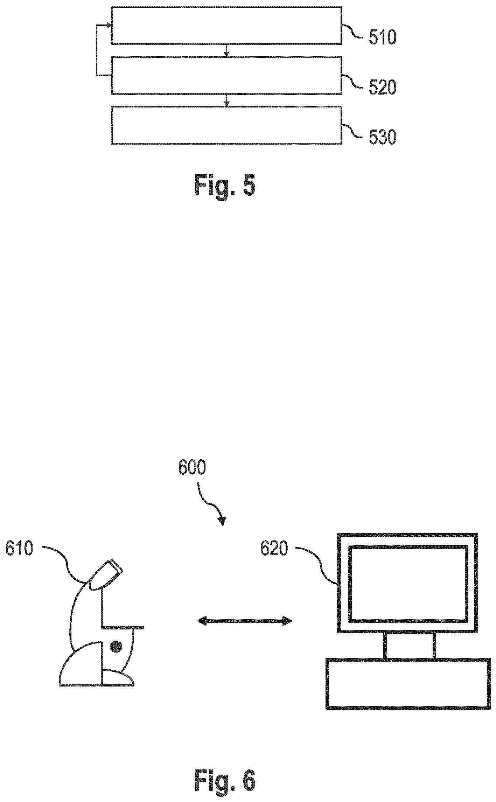

More details and aspects of the sample preparation device 100 and the control system 110 are mentioned in connection with the proposed concept or one or more examples described above or below (e.g., Figs. 5 to 6). The sample preparation device 100 and the control system 110 may comprise one or more additional optional features corresponding to one or more aspects of the proposed concept or one or more examples described above or below.

Fig. 5 shows a flow chart of an example of a method for a sample preparation device, e.g., for the sample preparation device 100 of Fig. 1. The method comprises obtaining 510 a plurality of sensor data sets of a positioning sensor of the sample preparation device. Each sensor data set is indicative of a position of at least one reference point on a sample within the sample preparation device. The method comprises controlling 520, between obtaining successive sensor data sets of the plurality of sensor data sets, a positioning mechanism of the sample preparation device to change at least one of a position or orientation of the sample relative to the positioning sensor by a defined distance and/or defined angle. The method comprises determining 530 at least one of the position or orientation of the sample within the sample preparation device based on the plurality of sensor data sets. For example, the method of Fig. 5 may comprise one or more additional features introduced in connection with the corresponding sample preparation device 100 and/or control system 110 of Figs. 1 to 4. For example, the method may comprise one or more features ascribed to the control system 110.

More details and aspects of the method are mentioned in connection with the proposed concept or one or more examples described above or below (e.g., Figs. 1 to 4, 6). The method may comprise one or more additional optional features corresponding to one or more aspects of the proposed concept or one or more examples described above or below.

As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Some embodiments relate to a microscope comprising a system as described in connection with one or more of the Figs. 1 to 5. Alternatively, a microscope may be part of or connected to a system as described in connection with one or more of the Figs. 1 to 5. Fig. 6 shows a schematic illustration of a system 600 configured to perform a method described herein. The system 600 comprises a microscope 610 and a computer system 620. The microscope 610 is configured to take images and is connected to the computer system 620. The computer system 620 is configured to execute at least a part of a method described herein. The computer system 620 may be configured to execute a machine learning algorithm. The computer system 620 and microscope 610 may be separate entities but can also be integrated together in one common housing. The computer system 620 may be part of a central processing system of the microscope 610 and/or the computer system 620 may be part of a subcomponent of the microscope 610, such as a sensor, an actor, a camera or an illumination unit, etc. of the microscope 610.

The computer system 620 may be a local computer device (e.g. personal computer, laptop, tablet computer or mobile phone) with one or more processors and one or more storage devices or may be a distributed computer system (e.g. a cloud computing system with one or more processors and one or more storage devices distributed at various locations, for example, at a local client and/or one or more remote server farms and/or data centers). The computer system 620 may comprise any circuit or combination of circuits. In one embodiment, the computer system 620 may include one or more processors which can be of any type. As used herein, processor may mean any type of computational circuit, such as but not limited to a microprocessor, a microcontroller, a complex instruction set computing (CISC) microprocessor, a reduced instruction set computing (RISC) microprocessor, a very long instruction word (VLIW) microprocessor, a graphics processor, a digital signal processor (DSP), multiple core processor, a field programmable gate array (FPGA), for example, of a microscope or a microscope component (e.g. camera) or any other type of processor or processing circuit. Other types of circuits that may be included in the computer system 620 may be a custom circuit, an application-specific integrated circuit (ASIC), or the like, such as, for example, one or more circuits (such as a communication circuit) for use in wireless devices like mobile telephones, tablet computers, laptop computers, two-way radios, and similar electronic systems. The computer system 620 may include one or more storage devices, which may include one or more memory elements suitable to the particular application, such as a main memory in the form of random access memory (RAM), one or more hard drives, and/or one or more drives that handle removable media such as compact disks (CD), flash memory cards, digital video disk (DVD), and the like. The computer system 620 may also include a display device, one or more speakers, and a keyboard and/or controller, which can include a mouse, trackball, touch screen, voice-recognition device, or any other device that permits a system user to input information into and receive information from the computer system 620.

Some or all of the method steps may be executed by (or using) a hardware apparatus, like for example, a processor, a microprocessor, a programmable computer or an electronic circuit. In some embodiments, some one or more of the most important method steps may be executed by such an apparatus.

Depending on certain implementation requirements, embodiments of the invention can be implemented in hardware or in software. The implementation can be performed using a non-transitory storage medium such as a digital storage medium, for example a floppy disc, a DVD, a Blu-Ray, a CD, a ROM, a PROM, and EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may, for example, be stored on a machine readable carrier.

Other embodiments comprise the computer program for performing one of the methods described herein, stored on a machine readable carrier.

In other words, an embodiment of the present invention is, therefore, a computer program having a program code for performing one of the methods described herein, when the computer program runs on a computer.

A further embodiment of the present invention is, therefore, a storage medium (or a data carrier, or a computer-readable medium) comprising, stored thereon, the computer program for performing one of the methods described herein when it is performed by a processor. The data carrier, the digital storage medium or the recorded medium are typically tangible and/or non-transitionary. A further embodiment of the present invention is an apparatus as described herein comprising a processor and the storage medium.

A further embodiment of the invention is, therefore, a data stream or a sequence of signals representing the computer program for performing one of the methods described herein. The data stream or the sequence of signals may, for example, be configured to be transferred via a data communication connection, for example, via the internet.

A further embodiment comprises a processing means, for example, a computer or a programmable logic device, configured to, or adapted to, perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example, a field programmable gate array) may be used to perform some or all the functionalities of the methods described herein. In some embodiments, a field programmable gate array may cooperate with a microprocessor to perform one of the methods described herein. Generally, the methods are preferably performed by any hardware apparatus.

### List of reference Signs

- 10:: Sample
- 100:: Sample preparation device
- 110:: Control system
- 112:: Interface
- 114:: Processor
- 116:: Storage device
- 120:: Microscope (positioning sensor)
- 130:: Positioning mechanism
- 140:: Sample stage
- 150:: Sample preparation mechanism
- 160:: Second positioning mechanism
- 170:: Touchscreen user interface
- 210:: Sample
- 211:: Inner structure of the sample
- 220:: Axis
- 230:: Corner point (reference point)
- 240:: Contour point (reference point)
- 250:: Circle
- 400:: Corner point
- 410:: Straight line
- 411, 412, 413:: Reference point
- 420:: Straight line
- 421, 422, 423:: Reference point
- 510:: Obtaining sensor data sets of a positioning sensor
- 520:: Controlling a positioning mechanism
- 530:: Determining a position/orientation of a sample
- 600:: System
- 610:: Microscope
- 620:: Computer system

## Claims

1. A control system (110) for a sample preparation device (100), the control system comprising one or more processors (114) and one or more storage devices (116), wherein the control system is configured to:
obtain a plurality of sensor data sets of a positioning sensor (120) of the sample preparation device, with each sensor data set being indicative of a position of at least one reference point (230, 240, 411, 412, 413, 421, 422, 423) on a sample (10, 210) within the sample preparation device;
control, between obtaining successive sensor data sets of the plurality of sensor data sets, a positioning mechanism (130) of the sample preparation device to change at least one of a position or orientation of the sample relative to the positioning sensor by a defined distance and/or defined angle; and
determine at least one of the position or orientation of the sample within the sample preparation device based on the positions of the at least one reference point in the plurality of sensor data sets.

2. The control system according to claim 1, wherein the control system is configured to control the positioning mechanism to change the position of at least one reference point along a depth axis (200) defined by the positioning sensor (120), resulting in a change in distance between the positioning sensor and the at least one reference point, and to determine the position and/or orientation of the sample with respect to a three-dimensional coordinate system.

3. The control system according to one of the claims 1 or 2, wherein the control system is configured to control the positioning mechanism to rotate a sample stage hosting the sample around an axis (220),
and/or wherein the control system is configured to control the positioning mechanism to laterally and/or vertically move a sample stage hosting the sample relative to the positioning sensor, thereby causing a change in an angle of view of the positioning sensor on the sample.

4. The control system according to one of the claims 1 or 2, wherein the control system is configured to control the positioning mechanism to at least one of laterally move, vertically move, or rotate the positioning sensor.

5. The control system according to one of the claims 1 to 4, wherein the control system is configured to use a fitting algorithm to determine the position and/or orientation of the sample based on the positions of the at least one reference point indicated by at least two sensor data sets, by fitting the positions to a geometric shape of the sample and/or a geometric shape being based on the changed relative position or orientation.

6. The control system according to claim 5, wherein the control system is configured to, if the change in position or orientation if based on a rotation around an axis (220), fit the positions of the at least one reference point against at least one circle (250) being based on the rotation.

7. The control system according to one of the claims 5 or 6, wherein the control system is configured to, if the sensor data indicates the position of two or more reference points (411, 412, 413, 421, 422, 423) being located at the same edge of the sample, use the fitting algorithm to determine a straight line (410, 420) representing the edge of the sample, and to determine the position and/or orientation of the sample based on the straight line representing the edge of the sample.

8. The control system according to claim 7, wherein the control system is configured to, if the sensor data indicates the position of two sets of two or more reference points (411, 412, 413, 421, 422, 423) being located at two edges of the sample, with the two edges meeting at a corner of the sample, use the fitting algorithm to determine straight lines (410, 420) representing the edges of the sample, with the straight lines intersecting at the corner (400) of the sample, and to determine the position of the corner of the sample based on the position and orientation of the straight lines.

9. The control system according to one of the claims 5 to 8, wherein the control system is configured to use the fitting algorithm to fit the positions to a two-dimensional or three-dimensional model of the sample.

10. The control system according to one of the claims 1 to 9, wherein the control system is configured to obtain the sensor data sets of a microscope, or
wherein the sensor data sets comprise at least one of distance information or coordinate information, and the control system is configured to obtain the sensor data sets of one of a mechanical probing device, an electrical probing device, or a distance- or coordinate-coded sensor configured to provide distance-dependent sensor data.

11. The control system according to one of the claims 1 to 10, wherein the control system is configured to provide a user interface for a user of the sample preparation device, with the user interface comprising an input modality for selecting the position of the at least one reference point in the sensor data sets, and to determine the position and/or orientation of the sample within the sample preparation device based on the position of the at least one reference point selected by the user.

12. The control system according to one of the claims 1 to 10, wherein the control system is configured to automatically detect the position of the at least one reference point in the sensor data sets.

13. A sample preparation device comprising the control system (110) according to one of the claims 1 to 12, a chamber for holding a sample, a sample preparation mechanism, a positioning sensor (120), and a positioning mechanism (130), wherein the sample preparation device is a device for mechanically milling, polishing and/or cutting the sample.

14. A method for a sample preparation device, the method comprising:
Obtaining (510) a plurality of sensor data sets of a positioning sensor of the sample preparation device, with each sensor data set being indicative of a position of at least one reference point on a sample within the sample preparation device;
Controlling (520), between obtaining successive sensor data sets of the plurality of sensor data sets, a positioning mechanism of the sample preparation device to change at least one of a position or orientation of the sample relative to the positioning sensor by a defined distance and/or defined angle; and
Determining (530) at least one of the position or orientation of the sample within the sample preparation device based on the plurality of sensor data sets.

15. A computer program having a program code for performing the method according to claim 14 when the program is executed on a processor.
